# EUROPEAN PATENT APPLICATION

(11) **EP 4 475 174 A2**
(43) Date of publication of application: **11.12.2024**
(21) Application number: 24180076.2
(22) Date of filing: 05.06.2024
(51) Int. Cl.: H01L 21/8234, H01L 29/06, H01L 29/08, H01L 29/775

(54) **SEMICONDUCTOR DEVICE AND MANUFACTURING METHOD OF SEMICONDUCTOR DEVICE**

(30) Priority: 07.06.2023 US 202363471552 P; 11.10.2023 US 202318378943
(71) Applicant: Samsung Electronics Co., Ltd., Suwon-si, Gyeonggi-do 16677 (KR)
(72) Inventor: PARK, Keumseok, San Jose, CA, 95134 (US); HONG, Wonhyuk, San Jose, CA, 95134 (US); SEO, Kangill, San Jose, CA, 95134 (US)
(74) Representative: Kuhnen & Wacker Patent- und Rechtsanwaltsbüro PartG mbB

(57) **Abstract**

Provided is a semiconductor device 10 and a method of manufacturing the semiconductor device 10. The semiconductor device 10 includes: a 1^{st} source/drain region 135B connected to a 1^{st} channel structure 112; a 2^{nd} source/drain region 145, above the 1^{st} source/drain region 135B, connected to a 2^{nd} channel structure 122 above the 1^{st} channel structure 112; a backside contact structure 133 on a bottom surface of the 1^{st} source/drain region 135B; and a backside isolation structure 131 surrounding the backside contact structure 133, wherein the bottom surface of the 1^{st} source/drain region 135B is at a level below a top surface of the backside isolation structure 131.

## Description

### BACKGROUND

### 1. Field

Apparatuses and methods related to the disclosure relate to a semiconductor device in which a source/drain region is formed during a backside process of forming a backside power distribution network (BSPDN).

### 2. Description of the Related Art

A three-dimensionally (3D) stacked semiconductor device including a lower transistor and an upper transistor stacked thereon has been introduced in response to an increased demand for an integrated circuit having a high device density and performance. Each of the lower transistor and an upper transistor of the 3D-stacked semiconductor device may be implemented by a fin field-effect transistor (FinFET), a nanosheet transistor or any other type of transistor. The FinFET has one or more fin structures as a channel structure of the transistor. The fin structures vertically protrude from a substrate and horizontally extend, and at least three surfaces thereof are surrounded by a gate structure. The nanosheet transistor is characterized by one or more nanosheet channel layers as a channel structure of the transistor. The nanosheet channel layers vertically stacked based on a substrate and horizontally extend, and all four surfaces of each of the nanosheet channel layers are surrounded by a gate structure. The nanosheet transistor is referred to as gate-all-around (GAA) transistor, or as a multi-bridge channel field-effect transistor (MBCFET).

Along with the 3D-stacked semiconductor device, a backside power distribution network (BSPDN) formed at a back side of a semiconductor device has been developed and employed in semiconductor devices for the purpose of reducing device complexity at back-end-of-line (BEOL) structures such as high-density metal lines connecting front-end-of-line (FEOL) structures and middle-of-line (MOL) structures to an external circuit or voltage sources. For example, the FEOL structures include source/drain regions, channel structures, and gate structures, and the MOL structures include contact plugs formed on the FEOL structures to connect the FEOL structures to the BEOL structures.

The BSPDN formed on a back side of a 3D-stacked semiconductor device may include backside metal lines, such as a buried power rail, and backside contact structures. A backside contact structure may be formed on a bottom surface of a lower source/drain region (epitaxial structure) of the 3D-stacked semiconductor device (that is, a source/drain region of a lower transistor of the 3D-stacked semiconductor device), and the backside metal line may connect the backside contact structure to a voltage source or another circuit element.

However, as the contact poly pitch (CPP) of a 3D-stacked semiconductor device is further reduced to increase a device density, it becomes more difficult and complicated to form an upper source/drain region and a lower source/drain region that are vertically overlapping each other and various BEOL and MOL structures on a front side of the 3D-stacked semiconductor device. This is so even when the 3D-stacked semiconductor device is supported by the BSPDN structure formed on the back side thereof.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a semiconductor device in which a lower source/drain region for a lower transistor below an upper transistor is formed in a backside process forming a backside contact structure. The disclosure also provides a method of manufacturing this semiconductor device.

According to an embodiment, there is provided a semiconductor device which may include: a 1^{st} source/drain region connected to a 1^{st} channel structure; a 2^{nd} source/drain region, above the 1^{st} source/drain region, connected to a 2^{nd} channel structure above the 1^{st} channel structure; a backside contact structure on a bottom surface of the 1^{st} source/drain region; and a backside isolation structure surrounding the backside contact structure, wherein the bottom surface of the 1^{st} source/drain region is at a level below a top surface of the backside isolation structure.

According to an embodiment, the semiconductor device may further include: a gate structure surrounding the 1^{st} channel structure which includes a plurality of channel layers vertically stacked and extended in a channel-length direction; and a plurality of inner spacers, wherein the gate structure is formed between the channel layers, wherein the inner spacers are formed between the 1^{st} source/drain region and the gate structure formed between the channel layers, and wherein the bottom surface of the 1^{st} source/drain region is at a level below a bottom surface of the lowermost inner spacer among the inner spacers.

According to an embodiment, there is provided a semiconductor device which may include: a 1^{st} source/drain region connected to a 1^{st} channel structure; a passivation structure on the 1^{st} source/drain region; a frontside isolation structure on the passivation structure; a 2^{nd} source/drain region, on the frontside isolation structure, connected to a 2^{nd} channel structure above the 1^{st} channel structure; a gate structure surrounding the 1^{st} channel structure and the 2^{nd} channel structure; a backside contact structure on a bottom surface of the 1^{st} source/drain region; and a backside isolation structure surrounding the backside contact structure.

According to embodiments, the semiconductor device may further include a pluraltiy of inner spacers formed between the 1^{st} source/drain region and the gate structure, wherein a top surface of the 1^{st} source/drain region is at a level on or below a bottom surface of the uppermost inner spacer among the inner spacers.

According to embodiments, there is provided a method of manufacturing a semiconductor device. The method may include: (a) providing a plurality of semiconductor stacks each of which includes a 1^{st} channel structure and a 2^{nd} channel structure above the 1^{st} channel structure; (b) forming a frontside recess reaching an inside of a substrate, between the semiconductor stacks; (c) forming a sacrificial structure in the frontside recess such that the sacrificial structure fills in the inside of the substrate and is fomred on a side surface of the 1^{st} channel structure; (d) forming a 2^{nd} source/drain region based on the 2^{nd} channel structure; (e) replacing the substrate with a backside isolation structure; (f) removing the sacrificial structure to expose a side surface of the 1^{st} channel structure; and (g) forming a 1^{st} source/drain region based on the 1^{st} channel structure.

### BRIEF DESCRIPTION OF DRAWINGS

Example embodiments of the inventive concept will be more clearly understood from the following detailed description taken in conjunction with the accompanying drawings in which:
FIG. 1 illustrates a top plan view of an intermediate semiconductor device provided before source/drain regions are formed to manufacture a 3D-stacked semiconductor device, according to an embodiment;
FIGS. 2A-2K illustrate intermediate semiconductor devices obtained after respective steps of forming a 3D-stacked semiconductor device including a lower source/drain region formed in a backside process, according to embodiments;
FIGS. 3A-3D illustrate intermediate semiconductor devices obtained after respective steps of forming a 3D-stacked semiconductor device including a lower source/drain region formed in a backside process, according to other embodiments;
FIG. 4 illustrates a 3D-stacked semiconductor device including a lower source/drain region formed in a backside process, according another embodiment;
FIG. 5 illustrates a 3D-stacked semiconductor device including a lower source/drain region formed in a backside process, according still another embodiment
FIG. 6 illustrates a flowchart describing a method of forming lower source/drain regions and upper source/drain regions for a 3D-stacked semiconductor device, according to embodiments; and
FIG. 7 is a schematic block diagram illustrating an electronic device including a 3D-stacked semiconductor device including a lower source/drain region formed in a backside process as shown in FIGS. 2A-2K to 3A-3D, according to embodiments.

### DETAILED DESCRIPTION OF EXAMPLE EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to other element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions here below, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. For example, the disclosure may omit descriptions of materials of a source/drain region (e.g., silicon doped with p-type or n-type impurities), and a gate structure (e.g., copper (Cu), aluminum (Al), cobalt (Co), tungsten (W), titanium (Ti), tantalum (Ta) or their combination).

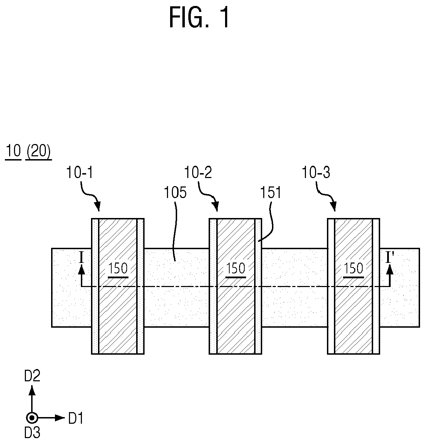

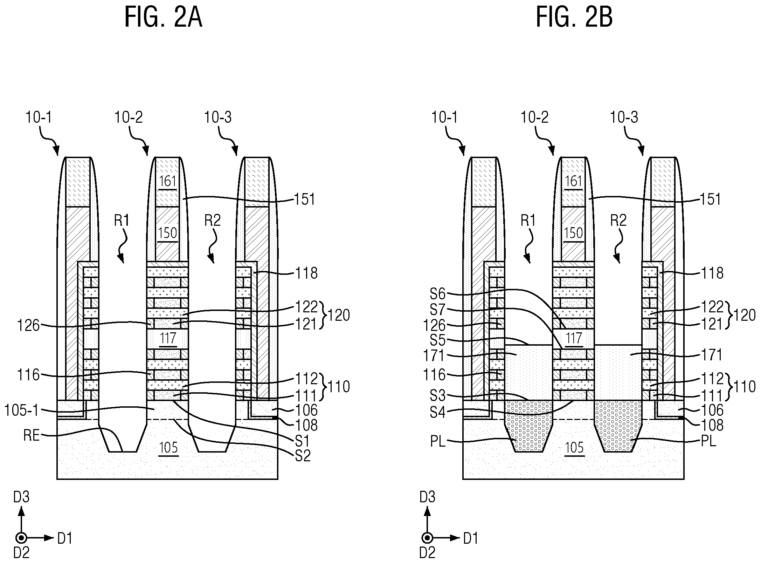

FIG. 1 illustrates a top plan view of an intermediate semiconductor device provided before source/drain regions are formed to manufacture a 3D-stacked semiconductor device, according to an embodiment. FIGS. 2A-2K illustrate intermediate semiconductor devices obtained after respective steps of forming source/drain regions and contact structures for a 3D-stacked semiconductor device based on the intermediate semiconductor device shown in FIG. 1, according to embodiments.

It is to be understood that FIG. 1 is provided only to show positional relationship between a plurality of elements of the 3D-stacked semiconductor device to help understanding of FIGS. 2A-2L. FIGS. 2A is a cross-section view of the intermediate semiconductor device of FIG. 1 along a line I-I' shown therein in a D1 direction, and FIGS. 2B through 2L are respective views along the same cross-sections in the D1 direction. Here, the D1 direction is a channel-length direction, a D2 direction is a channel-width direction that intersects the D1 direction, and a D3 direction vertically intersects the two horizontal directions D1 and D2.

Referring to FIGS. 1 and 2A, an intermediate semiconductor device including a plurality of semiconductor stacks 10-1, 10-2 and 10-3 on a substrate 105 may be provided. These three semiconductor stacks may be obtained by dividing a single initial semiconductor stack formed on the substrate 105 through, for example, operations of lithography, masking and top-down etching, to form two frontside recesses R1 and R2 between the semiconductor stacks. The frontside recesses R1 and R2 may reach from a front side of the intermediate semiconductor device to an inside of the substrate 105 below a level of a top surface S1 of the substrate 105 which may also be at the same level as a bottom surface of a lower channel structure of a 3D-stacked semiconductor device to be formed from the intermediate semiconductor device in a later step. For example, a bottom end RE of each of the frontside recesses R1 and R2 inside the substrate 105 may be formed below a level of a bottom end a bottom surface S2 of an active region 105-1 of the substrate 105 which may also be a top surface of a portion of the substrate 105 right below a shallow trench isolation (STI) structure 106 and an STI liner 108.

In the two frontside recesses R1 and R2 will be formed upper source/drain regions for a lower transistor and lower source/drain regions for an upper transistor in later steps of manufacturing a 3D-stacked semiconductor device from the intermediate semiconductor device shown in FIG. 2A. Further, as the two frontside recesses R1 and R2 are formed to reach down below the level of the bottom end of the active region 105-1, spaces to form backside contact structures for lower source/drain regions in a later step may be provided in this step.

The initial semiconductor stack, before being divided into the three semiconductor stacks 10-1, 10-2 and 10-3, may be formed by epitaxially growing a plurality of lower sacrificial layers 111, lower channel layers 112, upper sacrificial layers 121 and upper channel layers 122 from the active region 105-1 of the substrate 105 in an alternating manner. The sacrificial layers 111 and 121 are referred to as such because these layers will be replaced by a gate structure in a later step after supporting formation of other elements of a 3D-stacked semiconductor device. The lower channel layers 112 and the upper channel layers 122 will respectively form a lower channel for a lower transistor and an upper channel for an upper transistor with a channel isolation layer 117 therebetween when this intermediate semiconductor device is completed as the 3D-stacked semiconductor device in a later step. Herein, the lower sacrificial layers 111 and the lower channel layers 112 are collectively referred to as a lower channel structure 110, and the upper sacrificial layers 121 and the upper channel layers 122 are collectively referred to as an upper channel structure 120.

After the lower channel structure 110 and the upper channel structure 120 are stacked with the channel isolation layer 117 therebetween to form the initial semiconductor stack, the initial semiconductor stack may be patterned to form the STI structure 106 that will isolate the intermediate semiconductor device from an adjacent device such as another intermediate semiconductor device. The STI liner 108 may be formed before the STI structure 106 is formed on the substrate 105.

Further, an oxide layer 118 may be formed to surround the patterned semiconductor stack, and a dummy gate structure 150 may be formed on the oxide layer 118. The dummy gate structure 150 along with the sacrificial layers 111 will be replaced by a gate structure for a 3D-stacked semiconductor device in a later step. The oxide layer 118 may be formed to disable the channel structures 110 and 120 partially formed in the semiconductor stacks 10-1 and 10-3 when the 3D-stacked semiconductor device is completed. However, the semiconductor stacks 10-1 and 10-3 may be used to form lower source/drain regions and upper source/drain regions for the 3D-stacked semiconductor device in a later step.

Hard mask patterns 161 may be formed on the dummy gate structure 150 to perform lithography, masking and top-down etching operations on the initial semiconductor stack to obtain the semiconductor stacks 10-1, 10-2 and 10-3. Based on the hard mask patterns 161, the dummy gate structure 150 may be first patterned to form three dummy gate structures 150. A gate spacer 151 may be formed on side surfaces of the hard mask patterns 161 and each of the dummy gate structures 150. The gate spacer 151 will isolate or protect a gate structure which will replace each of the dummy gate structures 150 in a later step from other circuit elements.

Subsequently, the semiconductor stacks 10-1, 10-2 and 10-3 as shown in FIG. 2A may be patterned out with the above-described frontside recesses R1 and R2 therebetween each of which exposes an inside of the substrate 105 and side surfaces of the lower channel structure 110 and the upper channel structure 120 of the semiconductor stacks.

In addition, side surfaces of the lower sacrificial layers 111 may be etched to form lower inner spacers 116 which will isolate lower source/drain regions to be formed in a later step from portions of a gate structure which will replace the lower sacrificial layers 111 also in a later step. Similarly, side surfaces of the upper sacrificial layers 121 may be etched to form upper inner spacers 126 which will isolate upper source/drain regions to be formed in a later step from portions of the gate structure which will replace the upper sacrificial layers 121 also in a later step.

Thus, each of the frontside recesses R1 and R2 may expose side surfaces of the lower channel layers 112, the lower inner spacers 116, the channel isolation layer 117, the upper channel layers 122 and the upper inner spacers 126 which may be vertically aligned and coplanar with each other. Further, as the frontside recesses R1 and R2 may be formed such that the above-listed side surfaces are also vertically aligned and coplanar with side surfaces of at least a portion of the substrate 105, for example, the active region 105-1 of the substrate 105.

The substrate 105 may be a silicon (Si) substrate although it may include other materials such as silicon germanium (SiGe), silicon carbide (SiC). Each of the sacrificial lower layers 111 may include silicon-germanium (SiGe), and each of the channel lower layers 112 may include silicon (Si). The inner spacers 116 and 126 may include silicon nitride (e.g., SiN, SiBBN, Si₃N₄, etc.). The channel isolation layer 117 may also include SiGe, or a silicon nitride (e.g., SiBCN). The STI structure 106 may include a silicon oxide (e.g., SiO₂), and the STI liner 108 may include a silicon nitride (e.g., SiN or Si₃N₄). The oxide layer 118 may be a silicon oxide layer (e.g., SiO₂). The dummy gate structure 150 may include polysilicon or amorphous silicon, and the gate spacer 151 may include a silicon nitride (e.g., Si₃N₄). The hard mask patterns 161 may include a silicon nitride or titanium nitride (e.g., SiN, Si₃N₄ or TiN). The above-listed materials forming the corresponding structural elements do not limit the disclosure, and other equivalent materials may be used to form the corresponding structural elements unless specific materials are fixed for the corresponding structural elements, according to embodiments.

Referring to FIG. 2B, a placeholder structure PL may be formed in a lower portion of each of the frontside recesses R1 and R2 in the substrate 105 below the level of the top surface of the active region 105-1, and a passivation structure 171 may be formed on the placeholder structure PL to passivate the lower channel structure 110 from a later step of epitaxy on the upper channel structure 120.

The placeholder structure PL and the passivation structure 171 in each of the frontside recesses R1 and R2 may both be collectively referred to as a sacrificial structure because these structures will be removed and replaced by a backside contact structure and a lower source/drain region in later steps.

The placeholder structure PL may be formed by filling a material such as SiGe in the substrate 105 exposed by the frontside recesses R1 and R2 such that a top surface S3 of the placeholder structure 103 is formed at the same level as a bottom surface S4 of the lower channel structure 110, that is, bottom surfaces of the lowermost lower sacrificial layer 111 of the lower channel structure 110 and the lowermost lower inner spacer 116 which may be coplanar with or at the same level as the top surface S1 of the active region 105-1. The lowermost lower sacrificial layer 111 and the lowermost lower inner spacer 116 may be formed right below the lowermost lower channel layer 112. Further, side surfaces of at least an upper portion of each of the placeholder structure PL may be vertically aligned and coplanar with the side surfaces of the lower channel layers 112, the lower inner spacers 116, the channel isolation layer 117, the upper channel layers 122 and the upper inner spacers 126.

The formation of the placeholder structure PL may be performed through, for example, chemical vapor deposition (CVD), plasma enhanced CVD (PECVD), physical vapor deposition (PVD), atomic layer deposition (ALD), or a combination thereof, not being limited thereto.

Further, the passivation structure 171 which includes an oxide material such as silicon oxide (e.g., SiO₂), not being limited thereto, may be formed on the placeholder structure PL to cover the side surfaces of the lower channel structure 110 from which a lower source/drain region for the 3D-stacked semiconductor device will be grown. Thus, the passivation structure 171 may passivate the lower channel structure 110 from a process of epitaxial growth of an upper source/drain region from the upper channel structure 120 in a next step.

The formation of the passivation structure 171 may be performed through, for example, spin coating, chemical vapor deposition (CVD), and/or plasma enhanced CVD (PECVD), not being limited thereto, such that a top surface S5 of the passivation structure 171 is at a level between a top surface and a bottom surface of the channel isolation layer 117. Here, the top surface of the channel isolation layer 117 may be at the same level as bottom surfaces S6 of the lowermost upper sacrificial layer 121 and the lowermost upper inner spacer 126, and the bottom surface of the channel isolation layer 117 may be at the same level as top surfaces S7 of the uppermost lower sacrificial layer 111 and the uppermost lower inner spacer 116.

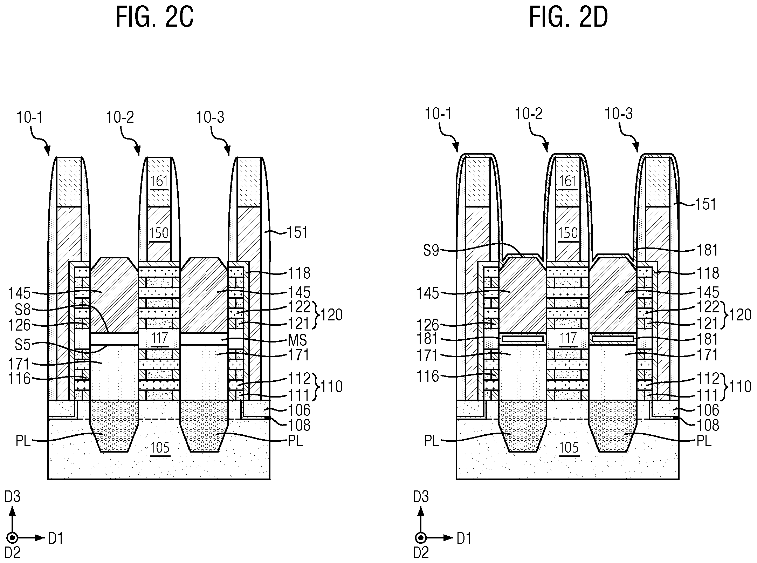

Referring to FIG. 2C, upper source/drain regions 145 may be formed in the frontside recesses R1 and R2, respectively, through, for example, epitaxy based on the upper channel layers 122 of the semiconductor stacks 10-1, 10-2 and 10-3, so that the upper channel layers 122 in these semiconductor stacks are connected to each other through the upper source/drain regions 145.

The epitaxy of the upper source/drain regions 145 may be performed through, for example, vapor-phase epitaxy (VPE), molecular-beam epitaxy (MBE), liquid-phase epitaxy (LPE) or other suitable or equivalent processes in which epitaxial materials (e.g., Si) is grown from gaseous or liquid precursors.

Further, during the epitaxy, the upper source/drain regions 145 may be doped with impurities such as phosphorus (P), arsenic (As), antimony (Sb), etc. when the upper source/drain regions 145 are to be n-type source/drain regions. However, when the upper source/drain regions 145 are to be p-type source/drain regions, they may be doped with boron (B), gallium (Ga), indium (In), etc.

When a 3D-stacked semiconductor device is completed, a current will flow between the upper source/drain regions 145 through the upper channel layers 122 of the semiconductor stack 10-2 to function an upper transistor of the 3D-stacked semiconductor device.

The epitaxial growth of the upper source/drain region 145 from the upper channel layers 122 in each of the frontside recesses R1 and R2 may be controlled such that a bottom surface S8 of the upper source/drain region 145 may not reach the top surface S5 of the passivation structure 171 to contact the passivation structure 171. Thus, an air gap MS may be formed between the bottom surface S8 of the upper source/drain region 145 and the top surface S5 of the passivation structure 171 there below, between side surfaces of the channel isolation layers 117 exposed in the frontside recesses R1 and R2.

Referring to FIG. 2D, a protection layer 181 may be formed to protect the upper source/drain regions 145 from a subsequent process including formation of a frontside isolation structure 141 on the intermediate semiconductor device obtained in the previous step.

The protection layer 181 may be formed through, for example, atomic layer deposition (ALD) of silicon nitride (e.g., SiN or Si₃N₄, not being limited thereto), on at least a top surface S9 and the bottom surface S8 of each of the upper source/drain regions 145, the top surface S5 of each of the passivation structures 171, the side surfaces of the channel isolation layers 117 exposed in the air gap MS, and side surfaces of the gate spacer 151 exposed through the frontside recesses R1 and R2.

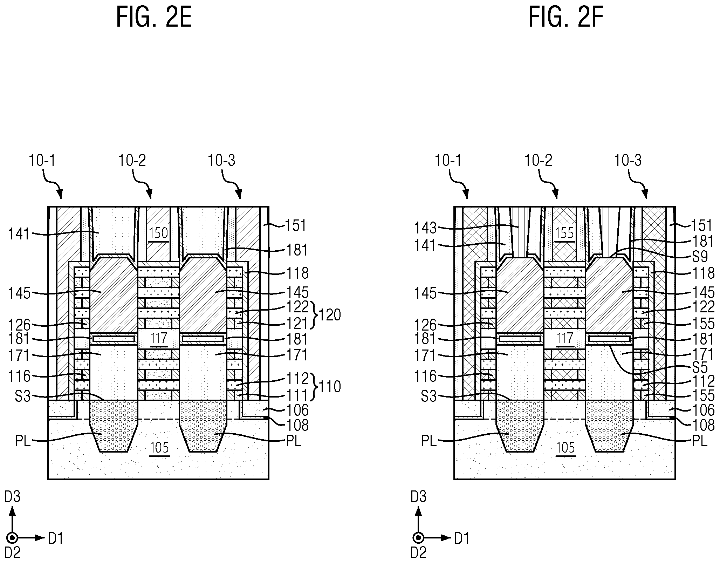

Referring to FIG. 2E, the hard mask patterns 161 and portions of the gate spacer 151 and the protection layer 181 at sides of the hard mask patterns 161 may be removed from the intermediate semiconductor device obtained in the previous step, and the frontside isolation structure 141 may be formed thereon to isolate the upper source/drain regions from each other and from other circuit elements including lower source/drain regions to be formed in a later step.

The removal of the hard mask patterns 161 and the portions of the gate spacer 151 and the protection layer 181 may be performed through, for example, plasma ashing, stripping and/or dry etching, not being limited thereto.

The frontside isolation structure 141 may be formed by depositing a dielectric material such as silicon oxide (e.g., SiO₂, not being limited thereto) to fill the frontside recesses R1 and R2 that still remain between the semiconductor stacks 10-1, 10-2 and 10-3 after the formation of the placeholder structures PL, the passivation structures 171, the upper source/drain regions 145, and further, the air gap MS in the previous steps. The frontside isolation structure 141 may also be formed between the upper source/drain region 145 and the passivation structure 171. The formation of the frontside isolation structure 141 may be performed through, for example, at least one of CVD, PVD, PECVD, etc., not being limited thereto.

Referring to FIG. 2F, the dummy gate structure 150 and the sacrificial layers 111 and 121 may be removed and replaced by a gate structure 155. Further, an upper contact structure 143 may be formed in the frontside isolation structure 141 to contact the top surface S9 of each of the upper source/drain regions 145.

The removal of the dummy gate structure 150 and the sacrificial layers 111 and 121 may be performed through, for example, dry etching, wet etching, reactive ion etching (RIE) and/or a chemical oxide removal (COR) process. The formation of the gate structure 155 may be performed through, for example, at least one of ALD, CVD, PVD, PECVD, etc. Now, the gate structure 155 may surround the channel layers 112 and 122 as a gate structure for a lower transistor and an upper transistor of a 3D-stacked semiconductor device.

The upper contact structure 143 may be formed through, for example, photolithography, masking and etching on the frontside isolation structure 141 to obtain a hole penetrating the frontside isolation structure 141 and the protection layer 181 to expose the top surface S9 of each of the upper source/drain regions 145, followed by depositing a meal or metal compound such as copper (Cu), aluminum (Al), cobalt (Co), tungsten (W), titanium (Ti), tantalum (Ta) or their combination.

The upper contact structure 143 formed on the top surface S9 of the upper source/drain region 145 may be connected to a BEOL structure such as a metal line to connect the upper source/drain region 145 with a voltage source or another circuit element for internal routing.

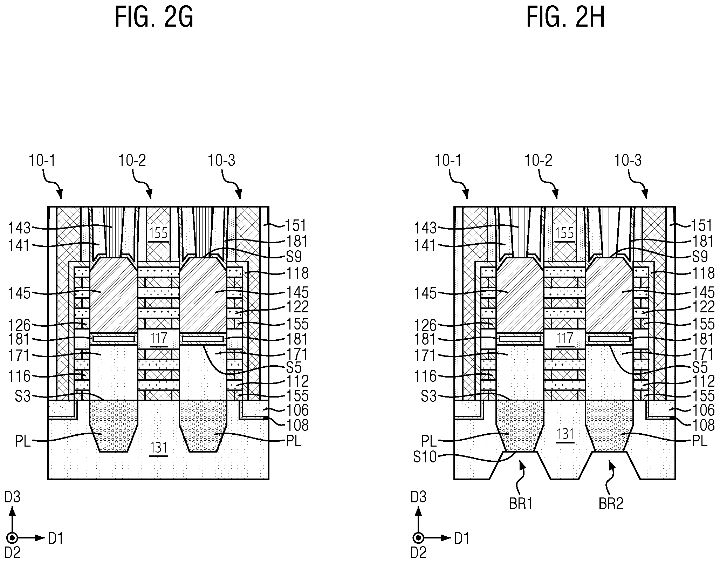

Referring to FIG. 2G, the substrate 105 in which the placeholder structures PL are formed may be removed and replaced by a backside isolation structure 131. Thus, the backside isolation structure 131 instead of the substrate 105 may now enclose the placeholder structures PL of which the top surfaces S3 are covered by the passivation structures 171.

The removal of the substrate 105 may be performed through, for example, wet etching, not being limited thereto, and formation of the backside isolation structure 131 in a space where the substrate 105 is removed may be performed through, for example, at least one of CVD, PVD, PECVD, etc., not being limited thereto. The backside isolation structure 131 may be formed of the same material forming the frontside isolation structure 141.

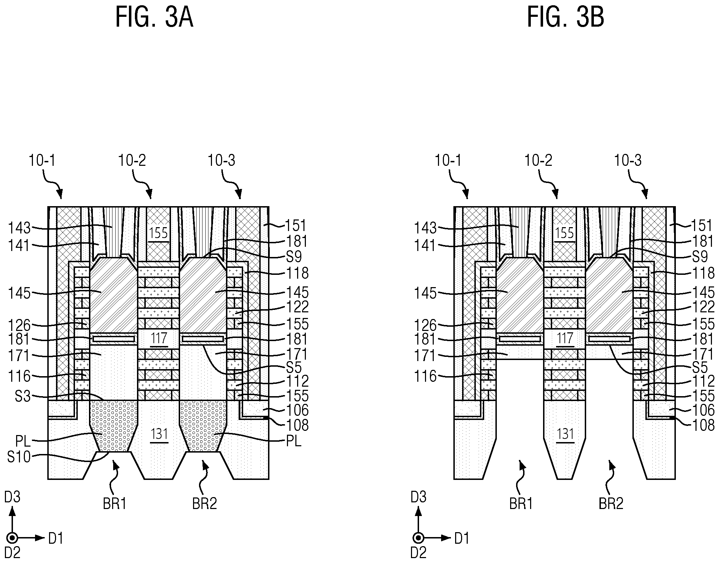

Although not shown in the drawings, the substrate replacement process in this step and subsequent steps to be described below in reference to FIGS. 2G-2J and 3A-3D may be performed after flipping upside down the intermediate semiconductor device obtained in the previous step.

Referring to FIG. 2H, backside recesses BR1 and BR2 may be formed to expose the placeholder structures PL formed in backside isolation structure 131. The formation of the backside recesses BR1 and BR2 may be performed through, for example, photolithography, masking and etching on the backside isolation structure 131 such that the backside recesses BR1 and BR2 expose a bottom surface S10 of each of the placeholder structures PL.

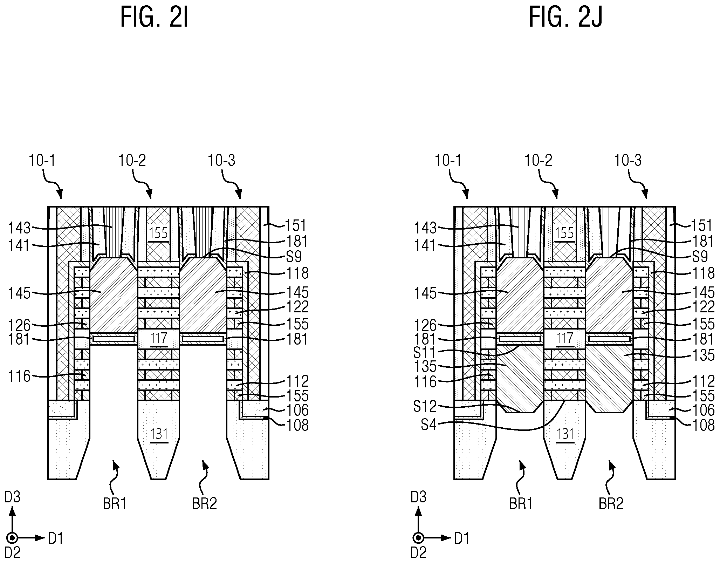

Referring to FIG. 2I, the placeholder structure PL and the passivation structure 171 may be removed as a sacrificial structure through each of the backside recesses BR1 and BR2 to expose at least side surfaces the lower channel layers 112 and the lower inner spacers 116 and the protection layer 181 formed on the top surface S5 of the passivation structure 171.

The removal of the placeholder structure PL may be performed through, for example, dry etching and/or wet etching using an etchant such as hydrofluoric acid (HF), nitric acid (HNO3) or their mixture that may selectively etch SiGe forming the placeholder structure PL against silicon oxide (e.g., SiO₂) forming the backside isolation structure 131.

The removal of the passivation structure 171 formed of silicon oxide (e.g., SiO₂) may be performed through, for example, dry etching and/or wet etching using a mixture of hydrofluoric acid (HF) and ammonium fluoride (NH4F), not being limited thereto, that may selectively etch silicon oxide (e.g., SiO₂) forming the passivation structure 171 against silicon (Si) forming the lower channel layers 112 and silicon nitride (e.g., SiN, SiBBN, Si₃N₄, etc.) forming the lower inner spacer 116, the channel isolation layer 117 and the protection layer 181.

As the placeholder structures PL and the passivation structures 171 are removed from the backside of the intermediate semiconductor device, the backside recesses BR1 and BR2 may be extended upward in a D3 direction to reach the protection layer 181 formed on the top surface S5 of the passivation structure 171, which is now removed.

Referring to FIG. 2J, lower source/drain regions 135 may be formed in the backside recesses BR1 and BR2, respectively, through, for example, epitaxy based on the lower channel layers 112 of the semiconductor stacks 10-1, 10-2 and 10-3, so that the lower channel layers 112 in these semiconductor stacks are connected to each other through the lower source/drain regions 135.

Here, the formation of the lower source/drain regions 135 may be performed such that each of the lower source/drain regions 135 is epitaxially grown from the lower channel layers 112 exposed between the lower inner spacers 116 in each of the backside recesses BR1 and BR2, and may cover the side surfaces of the lower inner spacers 116 and lower portions of the channel isolation layers 117. Further, the lower source/drain region 135 may be grown upward in the D3 direction so that a top surface S11 thereof reaches the protection layer 181 formed on the top surface S5 of the passivation structure 171 which is now removed, and a bottom surface S12 thereof reaches down beyond the bottom surfaces S4 of the lowermost lower sacrificial layer 111 or the lower most lower inner spacer 116 which may be at the same level as a top surface of the backside isolation structure 131. The bottom surface of S12 of the lower source/drain region 135 may also be at a level below a bottom surface of a portion the gate structure 155 that has replaced the lowermost lower sacrificial layer 111 which was at the same level as the bottom surface of the lowermost lower inner spacer 116 and the top surface of the backside isolation structure 131.

During the epitaxy, the lower source/drain regions 135 may also be doped with impurities such as phosphorus (P), arsenic (As), antimony (Sb), etc. when the lower source/drain regions 135 are to be n-type source/drain regions. However, when the lower source/drain regions 135 are to be p-type source/drain regions, they may be doped with boron (B), gallium (Ga), indium (In), etc.

When a 3D-stacked semiconductor device is completed, a current will flow between the lower source/drain regions 135 through the lower channel layers 112 of the semiconductor stack 10-2 to function a lower transistor of the 3D-stacked semiconductor device.

It is understood here that, in the present embodiment, the lower source/drain regions 135 may be formed through the backside recesses BR1 and BR2 in a backside process including removal of the placeholder structures PL while the upper source/drain regions 145 have been formed in the frontside recesses R1 and R2 in the frontside process. Thus, the present embodiment may prevent a short-circuit risk that exists in a related-art process of manufacturing a 3D-stacked semiconductor device in which all of the lower source/drain regions and the upper source/drain regions are formed in the frontside process.

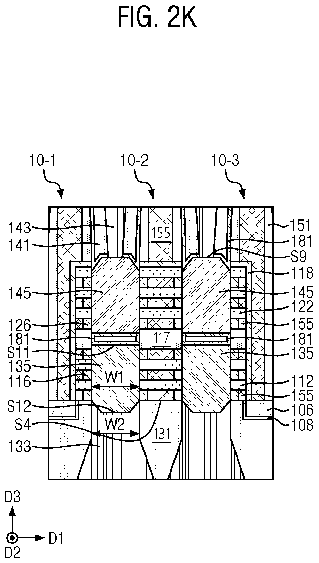

Referring to FIG. 2K, a backside contact structure 133 may be formed to contact the bottom surface S12 of each of the lower source/drain regions 135 through each of the backside recesses BR1 and BR2.

The formation of the backside contact structure 133 may be performed through, for example, at least one of CVD, PVD and PECVD, not being limited thereto, in the backside recesses BR1 and BR2 exposing the bottom surface S12 of each of the lower source/drain regions 135.

The backside contact structure 133 may be connected to a backside metal line connected to a voltage source or another circuit element for internal routing.

It is understood here that the backside contact structure 133 may be formed through each of the backside recesses BR1 and BR2 provided to form the lower source/drain regions 135, and thus, an entire bottom surface S12 of each of the lower source/drain regions 135 in the cross-section view of the D1 direction may be exposed in each of the backside recesses BR1 and BR2 after the formation of the lower source/drain regions 135.

Therefore, the backside contact structure 133 may be formed to contact the entire bottom surface S12 of the lower source/drain region 135 without an additional process of forming a hole reaching the lower source/drain region 135 in the backside isolation structure 131. Further, as the backside contact structure 133 may have an increased size to contact the entire bottom surface S12 of the lower source/drain region 135, a contact resistance of the backside contact structure 133 may also be reduced. For example, a width W1 of the lower source/drain region 135 between two horizontally adjacent lower channel layers 112 may be equal to a width W2 of an upper portion of the backside contact structure 133 contacting the lower source/drain region 135, in the D1 direction.

In the meantime, prior to the formation of the lower source/drain regions 135 (FIG. 2J) in the above embodiment, the passivation structures 171 may be removed entirely to expose the protection layer 181 formed on the top surfaces of the passivation structures 171 (FIG. 2I), and then, the lower source/drain regions 135 may be formed to contact the protection layer 181 (FIG. 2J) there above. However, the disclosure is not limited thereto, and, according to an embodiment, the lower source/drain regions for a 3D-stacked semiconductor device may be formed the backside recesses in a different manner.

FIGS. 3A-3D illustrate intermediate semiconductor devices obtained after respective steps of forming source/drain regions and contact structures for a 3D-stacked semiconductor device based on the intermediate semiconductor device shown in FIG. 1, according to other embodiments.

Referring to FIG. 3A, the intermediate semiconductor device shown therein is the same as that shown in FIG. 2H. Thus, duplicate descriptions of obtaining the intermediate semiconductor device shown in FIG. 3A are omitted here below.

Referring to FIG. 3B, the placeholder structures PL may be removed from the backside isolation structure 131, and further, a portion of the passivation structure 171 may be removed as a sacrificial structure through each of the backside recesses BR1 and BR2 to expose side surfaces the lower channel layers 112 and the lower inner spacers 116, except the uppermost lower inner spacers 116. The removal of the placeholder structures PL and the passivation structures 171 may be performed through the same processes as in the previous embodiment, and thus, duplicate descriptions may be omitted here below.

Here, it is understood that, unlike the entire removal of the placeholder structures PL and the passivation structures 171 in the previous embodiment as shown in FIG. 2I, each of the passivation structures 171 may be not entirely removed to expose the protection layer 181 there above. Thus, the passivation structure 171 in each of the extended backside recesses BR1 and BR2 may be only reduced to still remain on the side surfaces of the uppermost lower inner spacers 116. This controlled recess of the passivation structure 171 may be performed to prevent a lower source/drain region from being overgrown in an upward direction as will be described below.

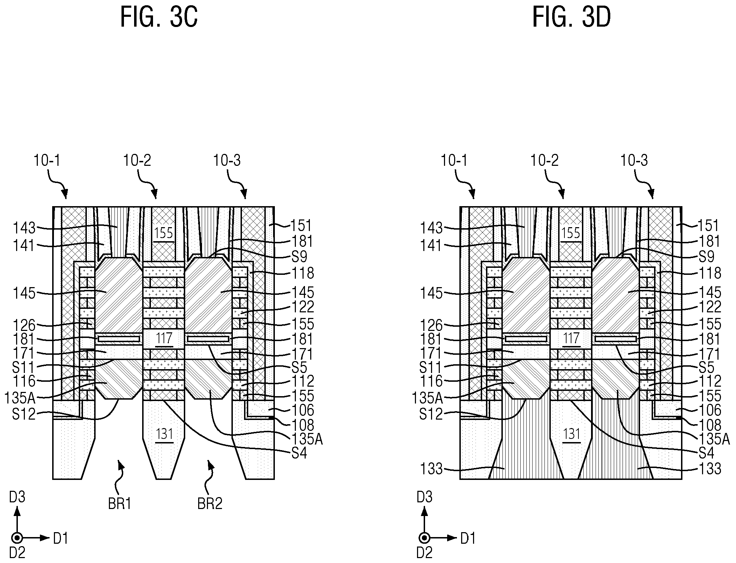

Referring to FIG. 3C, a lower source/drain region 135A may be formed in each of the extended backside recesses BR1 and BR2 with the reduced passivation structure 171 there above through, for example, epitaxial growth of silicon from the lower channel layers 112 of the semiconductor stacks 10-1, 10-2 and 10-3.

However, unlike in the previous embodiment, the epitaxial growth of the lower source/drain region 135A may be controlled based on the passivation structure 171, although reduced, still remaining in each of the backside recesses BR1 and BR2. Due to this passivation structure 171, the lower source/drain region 135A may not be overgrown from the lower channel layers 112 upward in the D3 direction to reach the protection layer 181 as in the previous embodiment shown in FIG. 2J.

The epitaxial growth of the lower source/drain region 135A may be additionally controlled by reducing at least a time duration of the epitaxy or adjusting an amount of the gaseous or liquid precursors for the epitaxy so that the lower source/drain region 135A may not be overgrown from the lower channel layers 112 down ward in the D3 direction at least below a level of the bottom surface of the lowermost lower inner spacer 116, which may be horizontally aligned or coplanar with the bottom surface S4 of the gate structure 155 and a top surface of the backside isolation structure 131.

Thus, the lower source/drain region 135A may be controlled to be smaller than the lower source/drain region 135 in the previous embodiment. As the size of the lower source/drain regions 135A decreases, a contact surface of the lower source/drain region 135A contacting the lower inner spacers 116 may also be reduced, and thus, parasitic capacitance may be reduced.

Referring to FIG. 3D, the same backside contact structure 133 may be formed to contact a bottom surface of each of the lower source/drain regions 135A in the same process described above in reference to FIG. 2J.

In the present embodiment, the lower source/drain region 135A is also formed through the backside process as in the previous embodiment, the short-circuit risk between lower and upper source/drain regions of the related-art 3D-stacked semiconductor device may be effectively prevented.

In the embodiment described in reference to FIGS. 3A-3D, the epitaxial growth of lower source/drain region 135A is controlled such that the lower source/drain region 135A is not overgrown downward as well as upward in the D3 direction. However, the disclosure is not limited thereto.

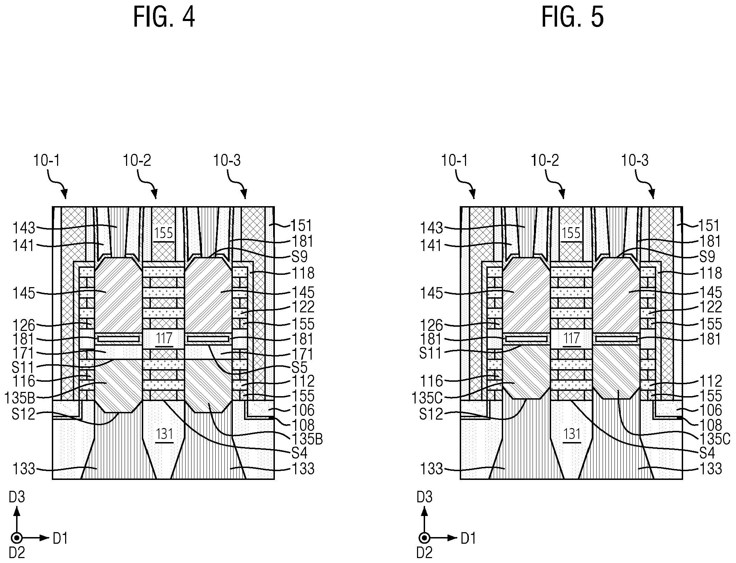

FIG. 4 illustrates a 3D-stacked semiconductor device including a lower source/drain region formed in a backside process, according another embodiment.

Referring to FIG. 4, a 3D-stacked semiconductor device may include the same structural elements of the 3D-stacked semiconductor device shown in FIG. 3D, except that a lower source/drain region 135B is formed such that a bottom surface thereof reaches downward below the level of the bottom surface of the lowermost lower inner spacer 116 and the gate structure 155 as shown in FIG. 2K. Still, however, the 3D-stacked semiconductor device in the present embodiment may include the reduced passivation structure 171. Thus, the epitaxial growth of the lower source/drain region 135B of the 3D-stacked semiconductor device 10 may be controlled only in the upward direction by the reduced passivation structure 171. In contrast, the bottom surface S12 of the lower source/drain region 135 may reach down to a level below the top surface of the backside isolation structure 131 which may be horizontally aligned and coplanar with the bottom surface S4 of the gate structure 155 or the lower most lower inner spacer 116.

FIG. 5 illustrates a 3D-stacked semiconductor device including a lower source/drain region formed in a backside process, according still another embodiment.

Referring to FIG. 5, a 3D-stacked semiconductor device may include the same structural elements of the 3D-stacked semiconductor device shown in FIG. 3D, except that the passivation structure 171 does not remain on a lower source/drain region 135C. Thus, while the epitaxial growth of the lower source/drain region 135C in the downward direction may be controlled as in the embodiment (FIG. 3D), the lower source/drain region 135C may still be overgrown in the upward direction as shown in FIG. 2K such that the top surface S11 thereof may be formed at a level above the top surface of the uppermost lower inner spacer 116 or contact the protection layer 181.

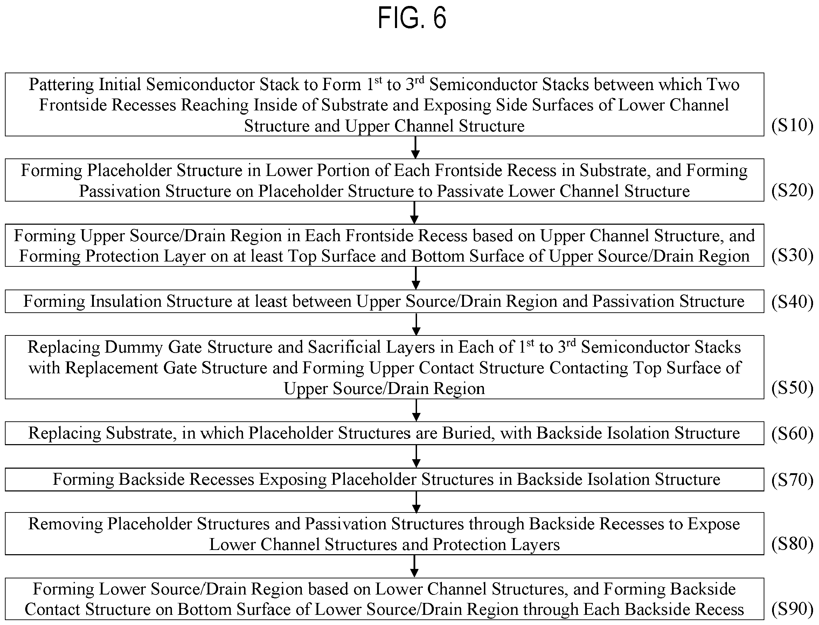

FIG. 6 illustrates a flowchart describing a method of forming lower source/drain regions and upper source/drain regions for a 3D-stacked semiconductor device, according to embodiments. This method is described here below in reference to FIGS. 1, 2A-2K and 3A-3D, and thus, the same reference numbers may be used in the following descriptions.

In step S10, an initial semiconductor stack including the lower channel structure 110 and the upper channel structure 120, with the channel isolation layer 117 therebetween, is patterned to provide the 1^{st} semiconductor stack 10-1, the 2^{nd} semiconductor stack 10-2 and the 3^{rd} semiconductor stack 10-3 with the dummy gate structure thereon 150 on the substrate 105 (FIG. 2A).

The 1^{st} semiconductor stack 10-1 and the 2^{nd} semiconductor stack 10-2 may be divided by a 1^{st} frontside recess R1, and the 2^{nd} semiconductor stack 10-2 and the 3^{rd} semiconductor stack 10-3 may be divided by a 2^{nd} frontside recess R2. The frontside recesses R1 and R2 may expose therein side surfaces of the lower channel structure 110 and the upper channel structure 120 of the semiconductor stacks 10-1, 10-2 and 10-3, and may further reach down inside of the substrate 105.

In step S20, the placeholder structure PL is formed in a lower portion of each of the frontside recesses R1 and R2 in the substrate 105, and the passivation structure 171 is formed on the placeholder structure PL to passivate the lower channel structure 110 in each of the frontside recesses R1 and R2 (FIG. 2B).

The placeholder structure PL and the passivation structure 171 may be a sacrificial structure to be removed and replaced by a backside contact structure and a lower source/drain region in a later step.

In step S30, the upper source/drain region 145 is formed based on the upper channel structure 120 in each of the frontside recesses R1 and R2, and the protection layer 181 is conformally formed on at least the top surface and the bottom surface of each of the upper source/drain regions 145 (FIG. 2C and 2D).

The protection layer 181 may also be formed on the top surface of each of the passivation structures 171, the side surfaces of the channel isolation layers 117 exposed in the air gap MS, and side surfaces of the gate spacer 151 exposed through the frontside recesses R1 and R2.

In step S40, the frontside isolation structure 141 is formed on the intermediate semiconductor device obtained in the previous step such that the frontside isolation structure is disposed at least between the upper source/drain region 145 and the passivation structure 171 (FIG. 2E).

In step S50, the dummy gate structure 150 and the sacrificial layers 111 and 121 in each of the semiconductor stacks 10-1, 10-2 and 10-3 are removed and replaced by the gate structure 155, and the upper contact structure 143 is formed to contact the top surface of each of the upper source/drain regions 145 (FIG. 2F).

In step S60, the substrate 105 in which the placeholder structures PL are formed is removed and replaced by the backside isolation structure 131 (FIG. 2G).

Thus, the placeholder structure PL may be now buried in the backside isolation structure 131 instead of the substrate 105.

Although not shown in the drawings, the substrate replacement process in this step and subsequent steps may be performed after flipping upside down the intermediate semiconductor device obtained in the previous step.

In step S70, the backside recesses BR1 and BR2 are formed to expose the placeholder structures PL formed in the backside isolation structure 131 (FIG. 2H).

In step S80, the placeholder structures PL and the passivation structures 171 as a sacrificial structure are removed through the backside recesses BR1 and BR2 to expose again at least the side surfaces the lower channel structures 110 and the protection layers 181 formed on the top surfaces of the passivation structures 171 (FIG. 2I).

As the placeholder structures PL and the passivation structures 171 are removed from the backside of the intermediate semiconductor device, the backside recesses BR1 and BR2 may be extended upward in the D3 direction to reach the protection layer 181s formed on the top surfaces of the passivation structures 171, respectively.

In step S90, the lower source/drain regions 135 are formed in the backside recesses BR1 and BR2, respectively, and the backside contact structures 133 are formed on the bottom surfaces of the lower source/drain regions 135, respectively (FIGS. 2J-2K).

In the above embodiments, a 3D-stacked semiconductor device including a lower source/drain region formed in a backside process is described as including of nanosheet field-effect transistors at lower and upper stacks. However, the disclosure is not limited thereto, and at least one of the lower and upper transistors of the 3D-stacked semiconductor device may be implemented by a FinFET or another type of transistor. Further, the above-described process may also apply to a single-stack semiconductor device.

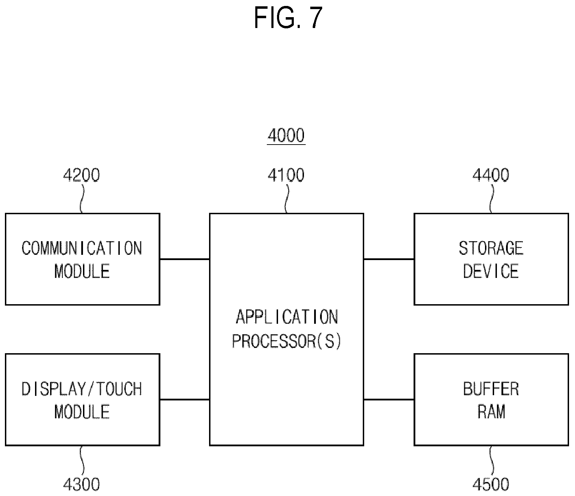

FIG. 7 is a schematic block diagram illustrating an electronic device including one or more 3D-stacked semiconductor devices including a lower source/drain region formed in a backside process as shown at least one of FIGS. 2K, 3D, 4 and 5 according to embodiments.

Referring to FIG. 7, an electronic device 4000 may include at least one application processor 4100, a communication module 4200, a display/touch module 4300, a storage device 4400, and a buffer RAM 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

At least one component in the electronic device 4000 may include one or more 3D-stacked semiconductor devices completed from the intermediate semiconductor device shown in at least one of FIGS. 2K, 3D, 4 and 5.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the disclosure.

## Claims

1. A semiconductor device (10) comprising:
a 1^{st} source/drain region (135) connected to a 1^{st} channel structure (110);
a 2^{nd} source/drain region (145), above the 1^{st} source/drain region (135), connected to a 2^{nd} channel structure (120) above the 1^{st} channel structure (110);
a backside contact structure (133) on a bottom surface of the 1^{st} source/drain region (135); and
a backside isolation structure (131) surrounding the backside contact structure (133),
wherein the bottom surface of the 1^{st} source/drain region (135) is at a level below a top surface of the backside isolation structure (131).

2. The semiconductor device (10) of claim 1, further comprising a gate structure (155) surrounding the 1^{st} channel structure (110),
wherein the bottom surface of the 1^{st} source/drain region (135) is at a level below a bottom surface of the gate structure (155).

3. The semiconductor device (10) of claim 1 or 2, further comrpising:
a gate structure (155) surrounding the 1^{st} channel structure (110) which comprises a plurality of channel layers (112) vertically stacked and extended in a channel-length direction; and
a plurality of inner spacers (116),
wherein the gate structure (155) is formed between the channel layers (112),
wherein the inner spacers (116) are formed between the 1^{st} source/drain region (135) and the gate structure (155) formed between the channel layers (112), and
wherein the bottom surface of the 1^{st} source/drain region (135) is at a level below a bottom surface of the lowermost inner spacer among the inner spacers (116).

4. The semiconductor device (10) of claim 3, wherein the bottom surface of the 1^{st} source/drain region (135) is at a level below a bottom surface of the gate structure (155).

5. The semiconductor device (10) of any one of claims 1 to 4, further comprising:
a frontside isolation structure (141) between the 1^{st} source/drain region (135) and the 2^{nd} source/drain region (145); and
a passivation structure (171) between the 1^{st} source/drain region (135) and the frontside isolation structure (141).

6. The semiconductor device (10) of claim 5, further comrising :
a gate structure (155) surrounding the 1^{st} channel structure (110) which comprises a plurality of channel layers (112) vertically stacked and extended in a channel-length direction; and
a plurality of inner spacers (116),
wherein the gate structure (155) is formed between the channel layers (112),
wherein the inner spacers (116) are formed between the 1^{st} source/drain region (135) and the gate structure (155) formed between the channel layers (112), and
wherein the passivation structure (171) is formed on a side surface of at least a portion of the uppermost inner spacer among the inner spacers (116).

7. A semiconductor device (10) comprising:
a 1^{st} source/drain region (135) connected to a 1^{st} channel structure (110);
a passivation structure (171) on the 1^{st} source/drain region (135);
a frontside isolation structure (141) on the passivation structure (171);
a 2^{nd} source/drain region (145), on the frontside isolation structure (141), connected to a 2^{nd} channel structure (120) above the 1^{st} channel structure (110);
a gate structure (155) surrounding the 1^{st} channel structure (110) and the 2^{nd} channel structure (120);
a backside contact structure (133) on a bottom surface of the 1^{st} source/drain region (135); and
a backside isolation structure (131) surrounding the backside contact structure (133).

8. The semiconductor device (10) of claim 7, further comprising:
a pluraltiy of inner spacers (116) formed between the 1^{st} source/drain region (135) and the gate structure (155),
wherein a top surface of the 1^{st} source/drain region (135) is at a level on or below a bottom surface of the uppermost inner spacer among the inner spacers (116).

9. The semiconductor device (10) of any one of claims 1, 7 and 8, wherein an upper portion of the backside contact structure (133) and the 1^{st} source/drain region (135) have an equal width in a channel length direction.

10. A semiconductor device (10) comprising:
a 1^{st} source/drain region (135) connected to a 1^{st} channel structure (110);
a 2^{nd} source/drain region (145), above the 1^{st} source/drain region (135), connected to a 2^{nd} channel structure (120) above the 1^{st} channel structure (110);
a backside contact structure (133) on a bottom surface of the 1^{st} source/drain region (135); and
a backside isolation structure (131) surrounding the backside contact structure (133),
wherein an upper portion of the backside contact structure (133) and the 1^{st} source/drain region (135) have an equal width in a channel length direction.

11. The semiconductor device (10) of any one of claims 1, 2 and 10, further comprising
a gate structure (155) surrounding the 1^{st} channel structure (110) which comprises a plurality of channel layers (112) vertically stacked and extended in a channel-length direction; and
a plurality of inner spacers (116),
wherein the gate structure (155) is formed between the channel layers (112),
wherein the inner spacers (116) are formed between the 1^{st} source/drain region (135) and the gate structure (155) formed between the channel layers (112), and
wherein a top surface of the 1^{st} source/drain region (135) is at a level on or above a top surface of the uppermost inner spacer among the inner spacers (116).

12. The semiconductor device (10) of claim 8 or 11, wherein the bottom surface of the 1^{st} source/drain region (135) is at a level on or above a bottom surface of the lowermost inner spacer among the inner spacers (116).

13. The semiconductor device (10) of any one of claims 1 to 9, 11 and 12, wherein:
the bottom surface of the 1^{st} source/drain region (135) is at a level on or above a bottom surface of the gate structure (155); and/or
the bottom surface of the 1^{st} source/drain region (135) is at a level on or above a top surface of the backside isolation structure (131) or the bottom surface of the 1^{st} source/drain region (135) is at a level below a top surface of the backside isolation structure (131).

14. A method of manufacturing a semiconductor device (10), the method comprising following operations:
(a) providing (S10) a plurality of semiconductor stacks (10-1, 10-2, 10-3) each of which comprises a 1^{st} channel structure (110) and a 2^{nd} channel structure (120) above the 1^{st} channel structure (110);
(b) forming (S10) a frontside recess reaching an inside of a substrate (105), between the semiconductor stacks (10-1, 10-2, 10-3);
(c) forming (S20) a sacrificial structure in the frontside recess such that the sacrificial structure is filled in the inside of the substrate (105) and is fomed on a side surface of the 1^{st} channel structure (110);
(d) forming (S30) a 2^{nd} source/drain region (145) based on the 2^{nd} channel structure (120);
(e) replacing (S60) the substrate (105) with a backside isolation structure (131);
(f) removing (S80) the sacrificial structure to expose a side surface of the 1^{st} channel structure (110); and
(g) forming (S90) a 1^{st} source/drain region (135) based on the 1^{st} channel structure (110).

15. The method of claim 14, further comprising forming a backside contact structure (133) on a bottom surface of the 1^{st} source/drain region (135); and
wherein:
an upper portion of the backside contact structure (133) and the 1^{st} source/drain region (135) have an equal width in a channel length direction, and/or
in operation (g), the 1^{st} source/drain region (135) is formed such that a bottom surface of the 1^{st} source/drain region (135) is at a level below a top surface of the backside isolation structure (131), and/or
in operation (f), the sacrificial structure is partially removed such that an upper portion thereof remains in the frontside recess, and in operation (g), a top surface of the 1^{st} source/drain region (135) contacts the upper portion of the sacrificial structure.
